# EUROPEAN PATENT APPLICATION

(11) **EP 4 723 833 A1**
(43) Date of publication of application: **08.04.2026**
(21) Application number: 24204228.1
(22) Date of filing: 02.10.2024
(51) Int. Cl.: H10D 30/69, H10D 64/68, G11C 11/404, G11C 16/04, H10B 12/00

(54) **A TRANSISTOR DEVICE, A MEMORY DEVICE AND A METHOD FOR OPERATING A MEMORY DEVICE**

(71) Applicant: Imec VZW, 3001 Leuven (BE)
(72) Inventor: GARBIN, Daniele, 3000 Leuven (BE); ROSMEULEN, Maarten, 9000 Gent (BE); MATSUBAYASHI, Daisuke, 3000 Leuven (BE); KAR, Gouri Sankar, 3001 Leuven (BE); BELMONTE, Attilio, 1030 Schaerbeek (BE)
(74) Representative: Lind Edlund Kenamets Intellectual Property AB

(57) **Abstract**

According to an aspect there is provided a field-effect transistor device (100) comprising:
a semiconductor layer (101) of a wide-bandgap semiconductor, the semiconductor layer comprising a source region (102), a drain region (104) and a floating body region (106) between the source region (102) and the drain region (104);
a first gate (108) and a second gate (110) arranged along the floating body region (106) of the semiconductor layer (101), wherein the first gate (108) is arranged at a first side (101a) of the semiconductor layer and the second gate is arranged at a second side (102b) of the semiconductor layer (101), opposite the first side (101a); and
a charge storage island (114) arranged along the floating body region (106) in contact with the second side (101b) of the semiconductor layer (101) such that the charge storage island (114) is arranged between the floating body region (106) and the second gate (110), wherein the charge storage island (114) is configured to define a potential well for charge carriers attracted from a channel induced in the floating body region (106) during an on-state of the transistor device (100).

## Description

### TECHNICAL FIELD

The present invention relates to a field-effect transistor (FET) device, a memory device and a method for operating a memory device.

### BACKGROUND

In a capacitor-less 1-transistor (1T) floating body dynamic random access memory (FB-DRAM) bit cell, the intrinsic floating body effect is used to store charge carriers in a floating body transistor of the bit cell, wherein a threshold voltage of the transistor may be varied. A state of the bit cell may thus be stored in the bit cell without relying on a separate capacitor. A stored state may be read by sensing a current through the bit cell. For instance, a greater amount of stored charge in the floating body tends to result in an increased threshold voltage of the transistor, which may be detected as a reduced cell current during read-out.

In the conventional FB-DRAM bit cell, one of the failure mechanisms is the leakage of the stored charge carriers (typically holes in Si-based devices) from the floating body to the source/drain regions of the transistor. This leakage may considerably limit the retention time of the bit cell.

### SUMMARY

It is an object of the present invention to provide a FET device suitable for a capacitor-less 1-transistor (1T) DRAM bit cell and having an improved design so as mitigate the above-mentioned issue with limited retention time. It is further an objective to provide a memory device comprising a capacitor-less one-transistor bit cell based on such a FET device so as to facilitate improved retention times of the bit cell. Further and alternative objectives may be appreciated from the following.

According to a first aspect of the present invention, there is provided a field-effect transistor (FET) device comprising:
a semiconductor layer of a wide-bandgap semiconductor, the semiconductor layer comprising a source region, a drain region and a floating body region between the source region and the drain region;
a first gate and a second gate arranged along the floating body region of the semiconductor layer, wherein the first gate is arranged at a first side of the semiconductor layer and the second gate is arranged at a second side of the semiconductor layer, opposite the first side; and
a charge storage island arranged along the floating body region in contact with the second side of the semiconductor layer such that the charge storage island is arranged between the floating body region and the second gate, wherein the charge storage island is configured to define a potential well for charge carriers attracted from a channel induced in the floating body region during an on-state of the transistor device.

The FET device of the first aspect is based on the insight that retention times of stored charge carriers (electrons or holes) may be improved by the provision of a charge storage island, between the floating body region of the semiconductor layer and the second gate. By defining a potential well along the floating body region, the charge storage island (which also is a floating island) may be used to store charge carriers. The first gate may, responsive to a sufficient gate voltage, induce a channel through the floating body region, between the source and drain regions, thereby switching the transistor to an on-state. The second gate may meanwhile be used to modulate the energy barrier of the potential well formed at the interface between the wide-bandgap material of the floating body region and the charge storage island. Charge carriers may thus be attracted/repelled to/from the charge storage island, from/to the channel induced in the floating body during the on-state. By varying the amount of charge on the charge storage island, the threshold voltage (and thus conductivity) of the FET device may in turn be varied.

By storing charge carriers in a charge storage island defining a potential well, a more efficient retention of the charge carriers may be provided, compared to a conventional floating body transistor relying on the floating body effect (FBE).

Using a wide-bandgap semiconductor as material for the semiconductor layer facilitates defining the potential well with a high energy barrier towards the floating body region, and thus increasing the retention time. Additionally, wide-bandgap semiconductors suitable as channel material in FET devices tend to enable low off-state leakage, which further may contribute to an increased retention time.

In the present disclosure, the term "wide-bandgap semiconductor" refers to a semiconductor with a greater bandgap than silicon (Si).

In some embodiments, the wide-bandgap semiconductor has a bandgap greater than 2 eV. A bandgap in this range enables defining a potential well with an energy barrier of a height sufficient for efficiently retaining stored charge carriers at the charge storage island.

In some embodiments, the wide-bandgap semiconductor is an oxide semiconductor such as IGZO, ZnO, InSnO or GaZnO. Oxide semiconductors enable a FET device with low off-state leakage. Oxide semiconductors, such as those exemplified, are also typically compatible with back-end-of-line (BEOL) processing. Another example of a wide-bandgap BEOL compatible semiconductor suitable as material for the semiconductor layer is a 2D semiconductor such as a transition metal dichalcogenide.

In the present disclosure, the term "charge storage island" refers to a feature, typically a layer, of a material different from the wide-bandgap semiconductor with a configuration such that a potential well is defined towards the wide-bandgap semiconductor during an off-state of the transistor device, i.e., at equilibrium. The off-state / equilibrium corresponds to a zero bias of the first gate, the second gate and source and drain regions.

The charge storage island may be formed of a conductor. The charge storage island may alternatively be formed of a doped semiconductor of a same conductivity type as the FET device.

In embodiments where the transistor device is an N-type device, the two following options are applicable:
In case the charge storage island is formed of a conductor (e.g., a metal), the potential well may be defined by the conductor having a work function such that the Fermi level of the conductor is lower than the conduction band edge of the floating body region during the off-state of the transistor device.

In case the charge storage island is formed of a semiconductor, the potential well may be defined by a conduction band edge of the semiconductor being at a lower energy level (due to a higher electron affinity and/or smaller bandgap than the wide-bandgap semiconductor) than the conduction band edge of the floating body region during the off-state of the transistor device.

In embodiments where the transistor device is a P-type device, the two following options are applicable:
In case the charge storage island is formed of a conductor (e.g., a metal), the potential well may be defined by the conductor having a work function such that the Fermi level of the conductor is higher than the valence band edge of the floating body region during the off-state of the transistor device.

In case the charge storage island is formed of a semiconductor, the potential well may be defined by a valence band edge of the semiconductor being at a higher energy level (due to a lower electron affinity and/or smaller bandgap than the wide-bandgap semiconductor) than the valence band edge of the floating body region during the off-state of the transistor device.

In some embodiments, the wide-bandgap semiconductor is an oxide semiconductor, the transistor device is an N-type device, and the charge storage island is formed of a metal, a metallic material, a silicide or an N-type semiconductor.

According to a second aspect of the present invention, there is provided a memory device comprising:
a capacitor-less one-transistor bit cell comprising a FET device according to the first aspect or any embodiments thereof; and
a write circuit configured to apply a program operation and an erase operation to the bit cell,
wherein the program operation comprises:
   biasing the source and drain regions and the first gate such that a channel is induced in the floating body region between the source and drain regions, and
   biasing the second gate such that charge carriers are attracted from the channel to the charge storage island; and
   wherein the erase operation comprises:
biasing the source and drain regions and the first gate such that a channel is induced in the floating body region, and
biasing the second gate such that charge carriers flow away from the charge storage island to the drain region via the channel.

According to a third aspect of the present invention, there is provided a method for operating a memory device according to the second aspect or any embodiments thereof, the method comprising, by the write circuit of the memory device, applying the program operation or the erase operation to the bit cell, wherein the program operation sets the bit cell to a programmed state and the erase operation sets the bit cell to an erased state, wherein the transistor device has a first threshold voltage in the programmed state and a second threshold voltage in the erased state.

The memory device according to the second aspect and the method according to the third aspect generally features the same effects and advantages as the FET device of the first aspect, as discussed above.

As further may be appreciated, the program operation attracts charge carriers from the channel to be stored in the potential well, thus charging the charge storage island, e.g., with electrons. The stored charge carriers will be retained in the potential well for some time after finishing the program operation, the time corresponding to the retention time of the FET device/bit cell. The charge carriers stored in potential well / charge storage island will induce an auxiliary electrical field in the floating body region, thereby altering the conductivity and thus the effective threshold voltage of the FET device. Conversely, the erase operation repels charge carriers stored in the potential well, thus discharging the charge storage island. The auxiliary electrical field may thus be reduced in strength, thereby altering the conductivity and the effective threshold voltage of the FET device relatively to the programmed state.

Thereby, the write circuit may by applying the program operation set the bit cell to a programmed state wherein the transistor device has a first threshold voltage, and by applying the erase operation set the bit cell to an erased state wherein the transistor device has a second threshold voltage. This enables a current-based sensing of the state of the bit cell, as further set out in the below.

In some embodiments, the program operation comprises applying gate voltages of a same polarity to the first and second gates, and the erase operation comprises applying gate voltages of opposite polarity to the first and second gates. The first and the second gates may hence during the program operation both attract free charge carriers. Conversely, during the erase operation, opposite polarity voltages of the first and second gates allows the first gate to (like in the program operation) induce the channel between the source and drain region, while the second gate may repel stored charge carriers from the charge storage island to the source or drain.

In some embodiments, the transistor device is an N-type device, wherein the program operation comprises applying positive gate voltages to the first and second gates, and wherein the erase operation comprises applying a positive gate voltage to the first gate and a negative gate voltage to the second gate. Hence, the positive gate voltages of the first and second gates may attract free charge carriers in the form of electrons to induce the channel and charge the charge storage island, respectively, during the program operation. Conversely, during the erase operation the negative gate voltage of the second gate may repel stored (excess) electrons from the charge storage island.

In some embodiments, the memory device further comprises a read circuit configured to apply a read operation to the bit cell, wherein the read operation comprises:
applying a drain-source read voltage to the source and drain regions of the transistor device, and a gate read voltage to the first gate, wherein the gate read voltage is between the first and second threshold voltages, and
determining whether the bit cell is in the programmed state or the erased state based on a magnitude of a drain-source current of the transistor device resulting in response to the gate and drain-source read voltages.

As mentioned above, the write circuit may by applying the program operation or erase operation set the threshold voltage of the transistor device to the first or second threshold voltage. The state of the bit cell, in terms of threshold voltage of the transistor device, may thus be determined based on a drain-source current sensed during the read operation. For instance, in an N-type device, and a charge storage island of metal, the programmed state may correspond to an increased negative charge on the charge storage island, thereby increasing the effective threshold voltage of the transistor device. Hence, the first threshold voltage (corresponding to the programmed state) may be a higher than the second threshold voltage (corresponding to the erased state).

### BRIEF DESCRIPTION OF THE DRAWINGS

The above, as well as additional objects, embodiments, features and effects of the present invention, may be better understood through the following illustrative and non-limiting detailed description, with reference to the appended drawings. In the drawings like reference numerals will be used for like elements unless stated otherwise.
Fig. 1 schematically shows a field-effect transistor (FET) device based on the floating-body effect (FBE) in accordance with a typical prior art implementation.
Fig. 2 schematically shows an example embodiment of a FET device.
Fig. 3 illustrates the FET device of Fig. 2 during a program operation.
Fig. 4 illustrates the FET device of Fig. 2 during an erase operation.
Fig. 5a-b illustrate the FET device during read operation when set to a programmed state and an erased state, respectively.
Fig. 6 schematically shows an example embodiment of a memory device 200, more specifically an FB-DRAM device

### DETAILED DESCRIPTION

The drawings are only schematic and the relative dimensions of illustrated elements, such as layers or other structures, may be exaggerated and not drawn to scale unless stated otherwise. Rather the dimensions may be adapted for illustrational clarity and to facilitate understanding.

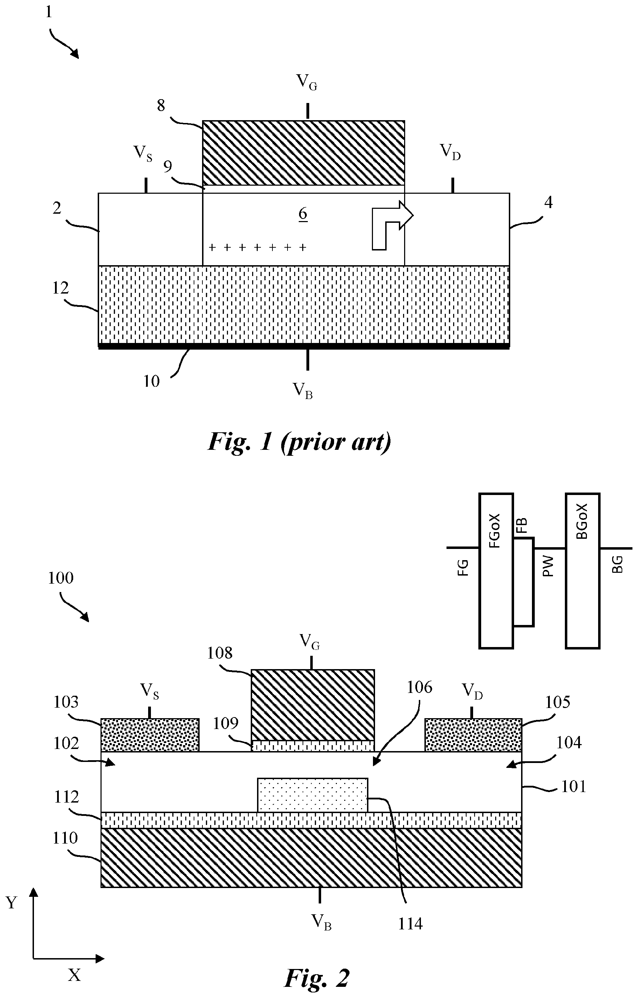

Fig. 1 schematically shows a field-effect transistor (FET) device 1 based on the floating-body effect (FBE) in accordance with a typical prior art implementation. The FET device 1 comprises a semiconductor layer comprising a source region 2, a drain region 4 and a floating body region 6 between the source and drain regions 2, 4. The semiconductor layer is typically a Si-layer, wherein the source and drain regions 2, 4 are highly-doped N type regions (N++) and the floating body region 6 is a P-type or intrinsic region. During operation, a front gate 8, separated from the semiconductor layer by a gate dielectric 9, is biased with an on-voltage V_{G} to induce a channel between the source and drain regions 2, 4, through the floating body region 6. By applying a sufficient drain-source voltage, holes (+) may be generated through impact ionization and/or band-to-band tunneling and be stored in the floating body 6. A back gate 10 arranged underneath an oxide layer 12 (e.g., a buried oxide layer) may be biased with a voltage V_{B} (e.g., less than 0 V) to attract the holes to the back interface between the floating body region 6 and the oxide layer 12. The bias voltage V_{B} at the back gate 10 needs to be sustained also after concluding the program operation to retain the holes and thus maintain the programmed state. Still, the stored holes tend to disappear over time, an effect known as retention loss. Example factors contributing to the retention loss in the FET device 1 is leakage to the front gate 8 through the gate dielectric 9, surface recombination at the back or front interface of the floating body region 6, recombination/generation in the floating body region 6, and junction leakage from the back interface to the source and drain regions 2, 4. The present disclosure provides approaches for reducing the retention loss by mitigating junction leakage, as set out in the following.

Fig. 2 schematically shows an example embodiment of a FET device 100 in accordance with the present invention. The FET device 100 is suitable for use in a capacitor-less 1T FB-DRAM bit cell.

The indicated axes X and Y point in a horizontal direction (corresponding to channel direction of the FET device 100) and a vertical direction (e.g., a direction normal or transverse to a non-shown substrate supporting the FET device 100).

The FET device 100 comprises a semiconductor layer 101 of a wide-bandgap semiconductor. The semiconductor layer 101 comprises a source region and a drain region, generally designated by reference signs 102 and 104, respectively. The source region 102 is contacted with a source terminal 103 and the drain region 104 is contacted with a drain terminal 105.

The semiconductor layer 101 further comprises a floating body region 106 located between the source region 102 and the drain region 104. The term "floating body region" as used herein signifies that the region 106 is configured to be floating (i.e., not connected to any fixed voltage such as ground) and thus may accumulate charge. The charge storage island 114 and the semiconductor layer 101 may as shown be arranged in direct contact with each other, and thus directly interface each other (e.g., define a metal-semiconductor interface, in case of a metal island, or a semiconductor-semiconductor interface, see below).

The FET device 100 comprises a first gate 108 and a second gate 110 arranged along the floating body region 106. The first gate 108 is arranged at a first side 101a of the semiconductor layer 101 and the second gate 110 is arranged at a second side 102b of the semiconductor layer 101, opposite the first side 101a. The first and second sides 101a, 101b may correspond to a frontside and a backside, respectively of the semiconductor layer 101. The first and second gates 108, 110 may thus be designated as a front gate and a back gate, respectively, of the FET device 100. The "frontside" may here correspond to the side of the semiconductor layer 101 facing away from an underlying substrate (not shown) of the FET device 100, while the "backside" may be the side facing the substrate.

The first/front gate 108 is separated from the first/front side 101a by a first/frontside gate dielectric 109. The second/back gate 110 is separated from the back side 101b by a second/backside gate dielectric 112.

The FET device 100 further comprises a charge storage island 114 arranged along the floating body region 106 at the second side 101b of the semiconductor layer 101. More specifically, the charge storage island 114 is arranged between the floating body region 106 and the second gate 110.

As described in further detail in the following, the charge storage island 114 is configured to define a potential well for free charge carriers attracted from a channel induced in the floating body region 106 during an on-state of the transistor device 100. To facilitate this process, the first/front gate 108 is configured to induce the channel between the source and drain regions 102, 104 through the floating body region 108. Meanwhile, the second/back gate 110 is configured to modulate the energy barrier of the potential well towards the wideband semiconductor of the floating body region 106 so as to either favor trapping (i.e., attract) or detrapping (i.e., repel) of charge carriers to/from the potential well.

The semiconductor layer 101 is as mentioned above formed of a wide-bandgap semiconductor. The thickness of the semiconduction layer 101 may for example be in a range from 3 nm to 30 nm. A bandgap of the wide-bandgap semiconductor may be 2 eV or more, typically 3 eV or more. The wide-bandgap semiconductor may be an oxide semiconductor such as IGZO, ZnO, InSnO or GaZnO. The wide-bandgap semiconductor may also be a 2D semiconductor such as such as a transition metal dichalcogenide MX2, where M is a transition metal such as W or Mo, and X is a chalcogen such as S or Se. Both oxide semiconductors and transition metal dichalcogenides may facilitate complementary metal oxide semiconductor (CMOS) BEOL-compatible device fabrication. The FET device 100 may thereby be suitable for use as a memory element in a BEOL-integrated memory array of a monolithic 3D integrated circuits (IC). However, also other thin-film wide-bandgap semiconductors are also possible. It is further noted that BEOL-compatibility is not a general requirement for the basic principles of operation of the FET device 100 set out below.

The charge storage island 114 is formed of a material with a Fermi-level exceeding a Fermi-level of the wide-bandgap semiconductor. The Fermi-level difference produces an energy barrier between the charge storage island 114 and the floating body region 104, thereby defining a potential well.

The inset in Fig. 2 is a schematic diagram of an example of the band alignment of the front gate 108 ("FG"), the floating body region 106 ("FB"), the potential well ("PW"), and the back gate 110 (BG). "FGoX" and "BGoX" denote the front and back gate dielectrics 109, 112, respectively. The band alignment is shown at equilibrium; where there is no biasing of the front gate 108, the back gate 110 or the source and drain regions 102, 104, which may correspond to a standby operation of the FET device 100, further discussed below. The potential well PW may as mentioned above be defined due to the Fermi-level of the charge storage island 114 being lower than the conduction band edge of (the wide-bandgap semiconductor of) the floating body region 106 at equilibrium, and may hence retain charges also in absence of front and back gate bias.

The charge storage island 114 may be formed of a conductor. The charge storage island may thus be a conductive island. A charge storage island of a conductor facilitates high storage capacity as well as trapping and detrapping of charge carriers at relatively modest back gate voltages. A conductor with a suitable work function may further enable a large difference between its Fermi-level and the conduction band edge of the wide-bandgap semiconductor at equilibrium, to define the potential well with a high energy barrier and thus good retention of charge carriers.

Examples of conductors for the charge storage island 114 include metal, a metallic material or a silicide. Examples of suitable metals include TaN, Hf and Al, or noble metals such as Pt. A benefit of noble metals is their inherent resistance to oxidizing, which facilitates avoiding forming of a parasitic insulating barrier between the charge storage island 114 and the semiconductor layer 101. Further examples of metals include Ru and Mo which, even if the oxidize, results in an oxide that can be conductive (metallic-like or small bandgap), thus also avoiding formation of a parasitic insulating barrier layer.

Examples of suitable metallic materials include metallic nanoparticles, nanodots or nanocrystals of cobalt, cobalt ferrite or nickel. Examples of suitable silicides include titanium silicide, cobalt silicide and nickel silicide.

A metal, metallic or silicide charge storage island may especially be suitable for storing charge carriers in the form of electrons, and thus advantageously be combined with an implementation of the FET device wherein the wide-bandgap semiconductor is an N-type semiconductor (wherein the channel induced in the floating body region 106 during the on-state of the FET device 100 is formed by free electrons). However, a metal, metallic or silicide charge storage island may also be combined with a P-type FET device, and thus store holes. In any case, a charge storage island 114 of metal (a "metal island") may also be advantageous from a device fabrication point-of-view in that the charge storage island 114 may be formed simply by depositing and patterning a metal layer.

The charge storage island 114 may alternatively be formed of a doped semiconductor of a same conductivity type as the FET device 100. The charge storage island 114 (semiconductor island) may thus be suitable for storing charge carriers of a same type as the free charge carriers of the channel of the FET device 100. Thus, for an N-type FET device 100 the charge storage island 114 may be formed by an N-type semiconductor. For a P-type FET device 100 the charge storage island 114 may be formed by a P-type semiconductor. A semiconductor island with a suitable electron affinity or bandgap difference relative the wide-bandgap semiconductor may further enable an energy level difference between the conduction band edges (in case of an N-type FET device) or between the valence band edges (in case of a P-type FET device) at equilibrium, to define the potential well with a high energy barrier and thus good retention of charge carriers. Examples of suitable semiconductors include poly-Si or amorphous Si. The depth of the potential well may be tuned via the doping level of the semiconductor island. For instance, a suitable N-type or P-type doping level of a poly-Si or amorphous Si semiconductor island may be 10¹⁹ cm⁻³ or higher, such as 10²⁰ cm⁻³ or higher.

Various length dimensions (as seen along the X axis) of the charge storage island 114 are possible. In Fig. 2, the charge storage island 114 and the front gate 108 are shown to be of comparable lengths, however, the charge storage island 114 may also be of smaller or greater length than the front gate 108. In general, a greater length of the charge storage island 114 results in a greater volume, and hence greater charge storage capacity of the charge storage island 114. On the other hand, a greater volume of the charge storage island 114 may lead to an increased footprint of the FET device 100 and thus limit the density of memory cells per unit area that can be achieved. In any case, the charge storage island 114 should not extend into the source and drain regions 102, 104 so as to create a short between the source and drain regions 102, 104.

According to an example fabrication process of the FET device 100, the charge storage island 114 may be formed on top of the back gate 110 and the backside gate dielectric 112. The charge storage island 114 may be formed by depositing a layer of the selected material of the charge storage island (e.g., conductor or semiconductor) and then patterning the layer to define the charge storage island 114 with a desired footprint. Subsequently, the semiconductor layer 101 may be formed on top of the back gate dielectric 112 and the charge storage island 114. The semiconductor layer 101 may be formed by depositing a wide-bandgap semiconductor layer and patterning the same to define the semiconductor layer 101 with a desired footprint. Following forming of the semiconductor layer 101, the process may proceed with forming the frontside gate dielectric 109 and the front gate 108, and the source/drain terminals 103, 105. The wide-bandgap semiconductor layer may typically be conformally deposited, on top of the backside gate dielectric 112 and the charge storage island 114. In this case, the semiconductor layer 101 may thus have a substantially uniform thickness, following the "step" defined by the charge storage island 114, such that the source, drain and floating body regions 102, 104, 106 have similar thickness. However, for the sake of simplicity, this feature has been omitted from the schematic depiction in Fig. 2.

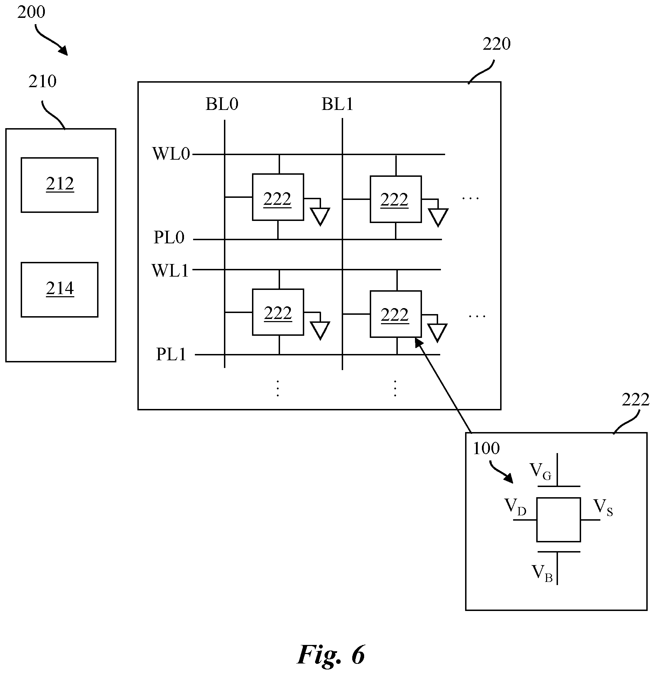

Fig. 6 schematically shows an example embodiment of a memory device 200, more specifically an FB-DRAM device. The memory device 200 comprises an array 220 of bit cells 222 arranged in a plurality of columns and rows. Each bit cell 222 is a capacitor-less 1T bit cell and comprises a FET device 100 corresponding to the FET device 100 discussed above. Each bit cell 222 is connected to a bit line BL0, BL1, etc., a word line WL0, WL1, etc. and a program line PL0, PL1, etc. More specifically, the FET device 100 of each bit cell 222 is arranged with the first gate 108 connected to a word line, the second gate 110 connected to a program line, and the drain region 104 connected to a bit line. The source region of each FET device 100 may as indicated be connected to a fixed voltage reference, such as VSS or ground.

The memory device 200 further comprises a memory controller 210. The circuitry of the memory controller 210 may be arranged in a periphery to the memory array 220. The memory controller 210 comprises a write circuit 212 and a read circuit 214. The write circuit 212 and the read circuit 214 are both connected to the bit cells 222 via the bit lines, word lines and program lines. The memory controller 210 may comprise additional circuitry such as column and row decoders and other conventional peripheral circuitry typical for DRAM, as per se is known in the art.

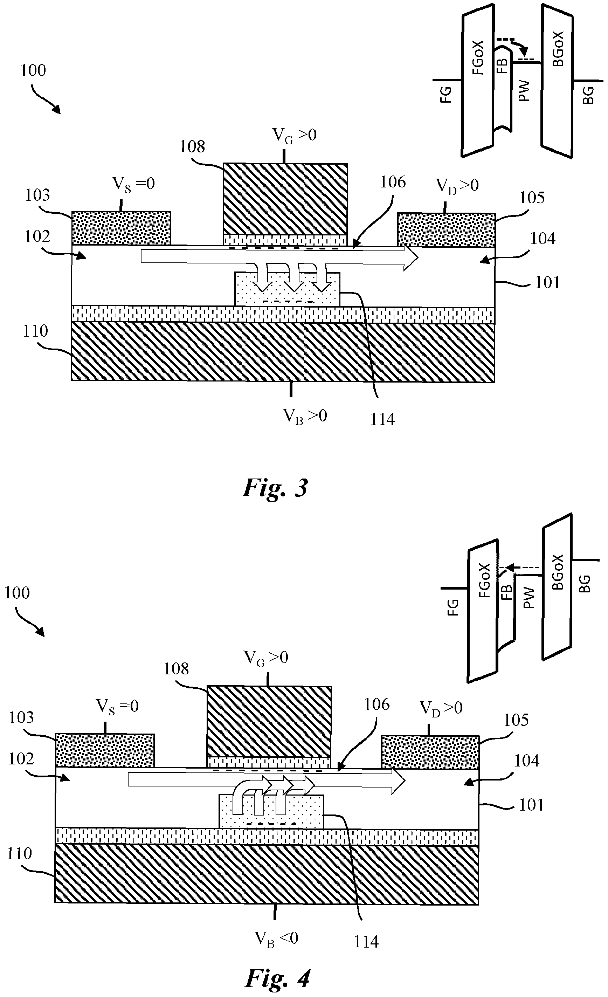

The write circuit 212 is configured to apply a program operation and an erase operation to any one of the bit cells 222. The read circuit 214 is configured to apply a read operation to any one of the bit cells 222. The program, erase and read operations applied to a FET device 100 will now be described with further reference to the illustrated examples of Fig. 3, 4 and 5a-b. Applying the program operation to a bit cell 222 sets the bit cell 222 to a programmed state. Applying the erase operation to a bit cell 222 sets the bit cell 222 to an erased state. Since the states of the bit cell 222 are stored by its FET device 100, the programmed state and erased state may equivalently be referred to as states of the FET device 100.

In the following examples it will be assumed that FET device 100 is an N-type device and that the charge storage island 114 is of a type suitable for storing electrons, as discussed above. For instance, the charge storage island 114 may in the following examples be formed as a metal island.

Fig. 3 illustrates the program operation wherein the FET device 100 is assumed to initially be in the erased state. The erased state may correspond to substantially no excess electrons being stored in the charge storage island 114. In the erased state, the FET device 100 has a threshold voltage in the following denoted "second threshold voltage V_{T2}".

During the program operation, the source and drain regions 102, 104, and the first/front gate 108 are biased such that a channel is induced in the floating body region 106 between the source and drain regions 102, 104, along the first/front side 101a of the semiconductor layer 101. Simultaneously, the second/back gate 110 is biased such that charge carriers are attracted from the channel to the charge storage island.

The drain voltage V_{D} may be a positive voltage greater than the source voltage Vs to achieve a positive drain-source voltage. The source voltage Vs may for instance be 0 V. The first/front gate voltage V_{G} applied to the first/front gate 108 during the program operation is set to a positive voltage V_{G} exceeding the second threshold voltage V_{T2} to switch the FET device 100 to the on-state and thus induce the channel. To attract free charge carriers of the channel (i.e., electrons) to the charge storage island 114, the second/back gate voltage V_{B} applied to the second/back gate 110 during the program operation is of a same polarity as the front gate voltage V_{G} (i.e., positive). The back gate voltage V_{B} may be of a level to attract an excess charge to the charge storage island 114 at a sufficient rate to conclude the program operation in a target time. The rate and the target time should be set such that the program operation causes a measurable shift of the effective threshold of the FET device 100, from the second threshold voltage V_{T2} to a first threshold voltage V_{T1} greater than V_{T2}. The specific level of the back gate voltage V_{B} during the program operation will depend on the height of the energy barrier of the potential well. However, it is envisaged that, typically, the back gate voltage V_{B} will be similar in magnitude to the front gate voltage V_{G}, or smaller.

Fig. 3 shows, in a corresponding manner to Fig. 2, the band alignment during the program operation. As may be seen, the back gate voltage V_{B} achieves a modulation of the energy barrier of the potential well PW and attracts electrons into the potential well.

To summarize, during the program operation, a positive front gate voltage V_{G} > V_{T2} (optionally V_{G} > V_{T1}, see below discussion) induces an electron channel through the floating body region 106 while a positive back gate voltage V_{B} attracts electrons into the potential well. The program operation may be concluded by turning off the FET device 100 (e.g., by setting V_{G} to 0 V), and returning the back gate voltage V_{B} to 0 V. Further, the drain-source voltage may be returned to 0 V. Upon concluding the program operation, some electrons may thus be trapped in the floating potential well, thereby setting the FET device 100 to the programmed state. The excess electrons charge carriers stored in potential well / charge storage island will induce an auxiliary electrical field in the floating body region 106, thereby altering the conductivity and thus causing the effective threshold voltage of the FET device 100 to be shifted from the second threshold voltage V_{T2} to the first threshold voltage V_{T1} > V_{T2}.

As the potential well is defined by the charge trap island 114, the stored charge carriers may be retained in the potential well during standby operation for some time after finishing the program operation, even in absence of a positive back gate bias V_{B}. The retention time will be determined at least in part by the size of the leakage current of the attracted charge carriers from the charge storage island 114 into the floating body region 106, which in turn depends on the height of the energy barrier of the potential well PW.

Fig. 4 illustrates the erase operation wherein the FET device 100 is assumed to initially be in the programmed state.

During the erase operation, the source and drain regions 102, 104 and the first gate 108 are, like during the program operation, biased such that a channel is induced in the floating body region 106 between the source and drain regions 102, 104, along the first/front side 101a of the semiconductor layer 101. Simultaneously, the second/back gate 110 is biased such that charge carriers flow away from the charge storage island 114 to join the channel and exit the floating body region 106 via the drain region 104. Thus, during erase, the voltage V_{B} applied to the second gate 110 is set to reduce the energy barrier of the potential well towards the floating body region 106 so as to favor detrapping of electrons.

The source and drain voltages V_{S}, V_{D} may here be the same as during the program operation, or in any case be set to achieve a positive drain-source voltage. Meanwhile, the front gate voltage V_{G} needs to be set to exceed the higher threshold voltage V_{T1} of the programmed state. It is possible to use different front gate voltages V_{G} during the program operation and the erase operation. However, it is also possible to use a same front gate voltage V_{G} during the erase and programming operations provided V_{G} > V_{T1}. The back gate voltage V_{B} may be of a level to repel excess charge from the charge storage island 114 at a sufficient rate to conclude the erase operation in a target time, i.e., remove substantially all excess electrons from the charge storage island 114 trapped during the program operation, to bring the threshold voltage back to the second threshold voltage V_{T2}.

Fig. 4 further shows, in correspondence with Fig. 3, the band alignment during the erase operation.

To summarize, during the erase operation, a positive front gate voltage V_{G} > V_{T1} induces an electron channel through the floating body region 106 while a negative back gate voltage V_{B} repels electrons from the potential well. The erase operation may be concluded by turning off the FET device 100 (e.g., by setting V_{G} to 0 V), and returning the back gate voltage V_{B} to 0 V. Further, the drain-source voltage may be returned to 0 V. Upon concluding the erase operation, little or substantially no excess electrons may thus be trapped in the floating potential well, thereby effectively reducing the auxiliary electrical field to zero, thereby setting the FET device 100 to the erased state and thus returning the threshold voltage of the FET device 100 to the second threshold voltage V_{T2}. Conversely, the erase operation repels charge carriers stored in the potential well, thus discharging the charge storage island.

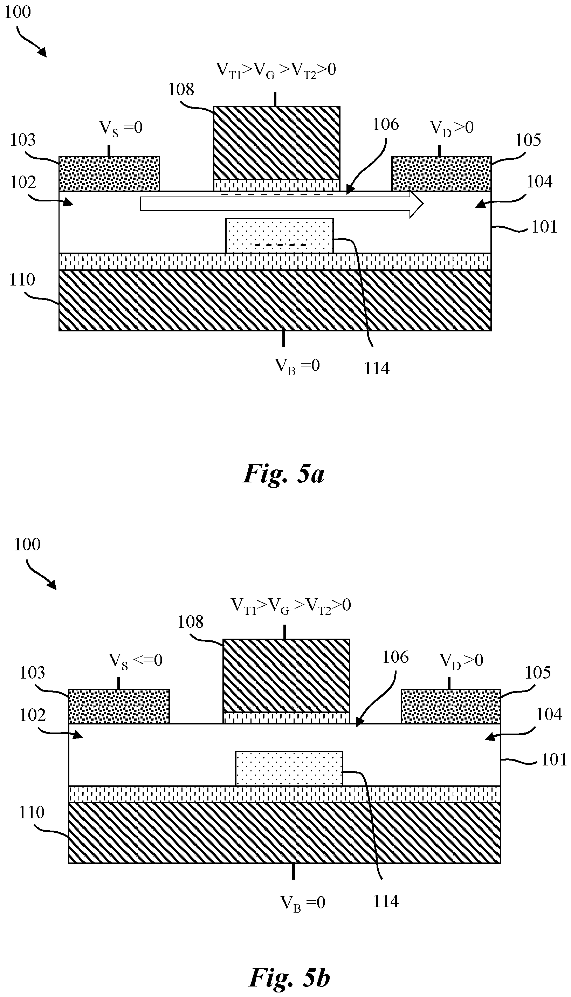

Fig. 5a-b illustrate the read operation wherein the FET device 100 is in the erased state (low threshold voltage state V_{T2}<V_{T1}) and the programmed state (high threshold voltage V_{T1}>V_{T2}), respectively.

During the read operation a drain-source read voltage (V_{D}-V_{S}, i.e., simply V_{D} assuming Vs = 0) is applied to the source and drain regions 102, 104, and a gate read voltage V_{G} is applied to the first/front gate 108. The gate read voltage is set to a level between the first and second threshold voltages VT₁, VT₂. Thus, during read, VT₁> V_{G}> VT₂>0. Thus, the FET device 100 will be switched to an on-state responsive to the gate read voltage only when set to the programmed state, as illustrated in Fig. 5a-b.

The read circuit 214 may thus determine whether the FET device 100 and its associated bit cell 222 is in the programmed state or the erased state based on a magnitude of a drain-source current of the FET device 100 resulting in response to the gate and drain-source read voltages. While in the illustrated example it is for simplicity indicated that the drain-source current is zero in the erased state, there may in practice still be a small drain-source current flowing through the FET device 100 also in the erased state, albeit smaller than in the programmed state.

To facilitate a read operation, the read circuit 214 may implement a differential sense amplifier, wherein the read current from a selected bit cell 222 may be compared to a reference current from another bit cell 222 in a known state, e.g., an erased state.

The person skilled in the art realizes that the present invention by no means is limited to the examples described above. On the contrary, many modifications and variations are possible within the scope of the appended claims. For example, in the above example, the program, erase and read operations have been described with reference to an N-type device, the principles of the operations may be applied also to a P-type device, by appropriate adaption of the polarities of the front and back gate voltages, to enable trapping and detrapping of holes from a P-type channel.

## Claims

1. A field-effect transistor device (100) comprising:
a semiconductor layer (101) of a wide-bandgap semiconductor, the semiconductor layer comprising a source region (102), a drain region (104) and a floating body region (106) between the source region (102) and the drain region (104);
a first gate (108) and a second gate (110) arranged along the floating body region (106) of the semiconductor layer (101), wherein the first gate (108) is arranged at a first side (101a) of the semiconductor layer and the second gate is arranged at a second side (102b) of the semiconductor layer (101), opposite the first side (101a); and
a charge storage island (114) arranged along the floating body region (106) in contact with the second side (101b) of the semiconductor layer (101) such that the charge storage island (114) is arranged between the floating body region (106) and the second gate (110), wherein the charge storage island (114) is configured to define a potential well for charge carriers attracted from a channel induced in the floating body region (106) during an on-state of the transistor device (100).

2. The transistor device according to claim 1, wherein the wide-bandgap semiconductor has a bandgap greater than 2 eV.

3. The transistor device according to any one of the preceding claims, wherein the wide-bandgap semiconductor is an oxide semiconductor such as IGZO, ZnO, InSnO or GaZnO, or a 2D semiconductor such as a transition metal dichalcogenide.

4. The transistor device according to any one of the preceding claims, wherein the charge storage island is formed of a conductor, or of a doped semiconductor of a same conductivity type as the transistor device.

5. The transistor device according to claim 4, wherein the transistor device is an N-type device and wherein the charge storage island is formed of a conductor having a work function such that a Fermi level of the conductor is lower than a conduction band edge of the floating body region during an off-state of the transistor device, or wherein the charge storage island is formed of a semiconductor having a conduction band edge at a lower energy level than a conduction band edge of the floating body region during an off-state of the transistor device.

6. The transistor device according to any one of claims 4-5, wherein the wide-bandgap semiconductor is an oxide semiconductor, the transistor device is an N-type device, and the charge storage island is formed of a metal, a metallic material, a silicide or an N-type semiconductor.

7. The transistor device according to claim 4, wherein the transistor device is a P-type device and wherein the charge storage island is formed of a conductor having a work function such that a Fermi level of the conductor is higher than a valence band edge of the floating body region during an off-state of the transistor device, or wherein the charge storage island is formed of a semiconductor having a valence band edge at a higher energy level than a valence band edge of the floating body region during the off-state of the transistor device.

8. A memory device (200) comprising:
a capacitor-less one-transistor bit cell (222) comprising a field-effect transistor device (100) according to any one of the preceding claims; and
a write circuit (212) configured to apply a program operation and an erase operation to the bit cell,
wherein the program operation comprises:
biasing the source and drain regions (102, 104) and the first gate (108) such that a channel is induced in the floating body region (106) between the source and drain regions (102, 104), and
biasing the second gate (110) such that charge carriers are attracted from the channel to the charge storage island (114); and
wherein the erase operation comprises:
biasing the source and drain regions (102, 104) and the first gate (108) such that a channel is induced in the floating body region (106), and
biasing the second gate (110) such that charge carriers flow away from the charge storage island (114) to the drain region (104) via the channel.

9. The memory device according to claim 8,
wherein the program operation comprises applying gate voltages of a same polarity to the first and second gates (108, 110), and
wherein the erase operation comprises applying gate voltages of opposite polarity to the first and second gates (108, 110).

10. The memory device according to any one of claims 8-9,
wherein the transistor device (100) is an N-type device,
wherein the program operation comprises applying positive gate voltages to the first and second gates (108, 110), and
wherein the erase operation comprises applying a positive gate voltage to the first gate (108) and a negative gate voltage to the second gate (110).

11. The memory device according to any one of claims 8-10, wherein the program operation sets the bit cell (222) to a programmed state and the erase operation sets the bit cell (222) to an erased state, wherein the transistor device (100) has a first threshold voltage in the programmed state and a second threshold voltage in the erased state, and
the memory device (200) further comprising a read circuit (214) configured to apply a read operation to the bit cell (222), wherein the read operation comprises:
applying a drain-source read voltage to the source and drain regions (102, 104) of the transistor device (100), and a gate read voltage to the first gate (108), wherein the gate read voltage is between the first and second threshold voltages, and
determining whether the bit cell (222) is in the programmed state or the erased state based on a magnitude of a drain-source current of the transistor device (100) resulting in response to the gate and drain-source read voltages.

12. A method for operating a memory device (200) according to any one of claims 8-11, the method comprising, by the write circuit (212) of the memory device (200), applying the program operation or the erase operation to the bit cell (222), wherein the program operation sets the bit cell (222) to a programmed state and the erase operation sets the bit cell (222) to an erased state, wherein the transistor device (100) has a first threshold voltage in the programmed state and a second threshold voltage in the erased state.

13. The method according to claim 12, when dependent on claim 11, further comprising, by the read circuit (214), subsequent to the write circuit applying the program operation or the erase operation to the bit cell (222), applying the read operation to the bit cell (222).
